# EUROPEAN PATENT APPLICATION

(11) **EP 4 657 077 A1**
(43) Date of publication of application: **03.12.2025**
(21) Application number: 25174392.8
(22) Date of filing: 06.05.2025
(51) Int. Cl.: G01P 1/00, G01P 15/097, G01P 21/00

(54) **THERMALLY STABILIZED ACCELEROMETER**

(30) Priority: 31.05.2024 US 202418680622
(71) Applicant: Honeywell International Inc., Charlotte, NC 28202 (US)
(72) Inventor: MEYER, Robert J., Charlotte, 28202 (US)
(74) Representative: Haseltine Lake Kempner LLP

(57) **Abstract**

An accelerometer includes a housing, a proof mass assembly encased in the housing, and one or more heating elements configured to heat the proof mass assembly in response to an electrical current. The one or more heating elements include a positive temperature coefficient of resistance (PTC) material. The PTC material exhibits a relatively high increase in resistance above a threshold temperature. For example, a ratio of the resistance of the PTC material above the threshold temperature to the resistance of the PTC material at room temperature (PTC ratio) is greater than five.

## Description

### TECHNICAL FIELD

The disclosure relates to accelerometers.

### BACKGROUND

Accelerometers function by detecting a displacement of a proof mass under inertial forces. For example, a vibrating beam accelerometer may detect the displacement of a proof mass by the change in frequency of a resonator connected between the proof mass and a support base. A resonator may be designed to change frequency proportional to the load applied to the resonator by the proof mass under acceleration. The resonator may be electrically coupled to signal generation circuitry forming an oscillator, which causes the resonator to vibrate at its resonant frequency. The displacement of the proof mass that is detected may be sensitive to changes in temperature. For accelerometers undergoing thermal transients that are not spatially uniform, this sensitivity may result in errors.

### SUMMARY

In general, the disclosure provides techniques to reduce errors in accelerometers caused by thermal transients. An accelerometer includes a housing and a proof mass assembly encased in the housing. During a thermal transient, the housing may experience temperature variation that may otherwise cause differential expansion of the proof mass assembly. To reduce this temperature variation, the accelerometer includes one or more heating elements that heat the proof mass assembly to a stable temperature. The heating elements include a positive temperature coefficient of resistance (PTC) material that exhibits a substantial increase in resistivity at a particular threshold temperature. In operation, the heating elements may quickly heat up to this threshold temperature, above which the increased resistance may substantially decrease power and hold the proof mass assembly at or near the threshold temperature. Such higher power dissipation at start-up may bring the accelerometer to stable operation faster than the normal operating power. In response to a thermal transient, the proof mass assembly may remain at or near the threshold temperature, albeit with a corresponding reduction in power to the heating elements for a positive thermal transient or an increase in power to the heating elements for a negative thermal transient. In this way, the proof mass assembly may be maintained at a relatively uniform temperature that reduces measurement errors that may result from spatial differences in temperature across the proof mass assembly.

In some examples, the disclosure describes an accelerometer that includes a housing, a proof mass assembly encased in the housing, and one or more heating elements configured to heat the proof mass assembly in response to an electrical current. The one or more heating elements include a positive temperature coefficient of resistance (PTC) material. The PTC material exhibits a relatively high increase in resistance above a threshold temperature.

In other examples, the disclosure describes a method for forming an accelerometer that includes forming one or more heating elements on at least one of a proof mass assembly or a housing for encasing the proof mass assembly and encasing the proof mass assembly in the housing. The one or more heating elements are configured to heat the proof mass assembly in response to an electrical current, wherein the one or more heating elements include a positive temperature coefficient of resistance (PTC) material. The PTC material exhibits a relatively high increase in resistance above a threshold temperature. No control circuitry is required as the PTC material adjusts its power consumption automatically in response to a temperature change. However, the current drawn by each heater can be used as a proxy for both temperature and differential temperature measurements. The time response of the PTC heating method is minimized due to the sensor and the heater being the same material.

In other examples, the disclosure describes a method, by processing circuitry, for measuring the differential temperature that includes causing a voltage source to deliver an electrical current to one or more heating elements to heat a proof mass assembly encased in a housing. The one or more heating elements include a positive temperature coefficient of resistance (PTC) material. The PTC material exhibits a relatively high increase in resistance above a threshold temperature. The method further includes determining one or more parameters corresponding to characteristics of the proof mass assembly and calculating the acceleration based on the one or more parameters of the proof mass assembly.

### BRIEF DESCRIPTION OF DRAWINGS

FIG. 1A is a block diagram illustrating an example accelerometer system.
FIG. 1B is a graph illustrating resistance versus temperature for an example positive temperature coefficient (PTC) material.
FIG. 2A is a flow diagram illustrating operation of one or more heating elements of an example accelerometer system.
FIG. 2B is a graph illustrating temperature versus time for an example accelerometer system.
FIG. 2C is a graph illustrating power versus time for an example accelerometer system.
FIG. 3A is a block diagram illustrating an example vibrating beam accelerometer that includes one or more heating elements.
FIG. 3B is a block diagram illustrating an example force rebalance accelerometer that includes one or more heating elements.
FIG. 3C is a block diagram illustrating an example micro electromechanical system (MEMS) accelerometer that includes one or more heating elements.
FIG. 4 is a flow diagram illustrating an example technique for fabricating an accelerometer that includes one or more heating elements.

### DETAILED DESCRIPTION

In general, the disclosure describes techniques to reduce measurement errors in accelerometers caused by spatial differences in temperature resulting from thermal transients. An accelerometer may undergo a thermal transient as a result of changing operating conditions. For example, an aircraft leaving cruising altitude may experience an increase in temperature due to friction forces or a change in temperature due to the atmospheric lapse rate, on the exterior of the aircraft. This change in temperature may cause the accelerometer to heat up unevenly, causing spatial temperature variations. Spatial temperature variations may cause non-uniform thermal expansion of parts of the accelerometer, and may result in uneven displacement of the proof mass and corresponding measurement error. To stabilize the temperature of the proof mass assembly and other components of the accelerometer, thermal control systems may measure a temperature of the accelerometer and actively heat or cool the accelerometer to maintain the accelerometer at a desired temperature. However, such active temperature control may be complex, costly, and heavy. Additionally, the temperature control mechanism may continue to heat or cool the accelerometer once the desired temperature has been reached, resulting in overshoot and continued temperature instability.

According to techniques described in the disclosure, an accelerometer includes one or more heating elements that heat the proof mass assembly to a stable temperature in a manner that does not require active control. Rather than measure the temperature and generate a proportional response, the heating elements operate based on a thermal self-regulation mechanism that limits an increase in temperature beyond a particular threshold temperature. The heating elements include a positive temperature coefficient of resistance (PTC) material that exhibits a substantial increase in resistivity at the particular threshold temperature.

In operation, the heating elements may quickly heat up to this threshold temperature, above which the increased resistance may substantially decrease power and hold the proof mass assembly at or near the threshold temperature. In response to a thermal transient, the proof mass assembly may remain at or near the threshold temperature. Overshoot may be reduced due to both temperature sensing and heating being provided by the same heating elements. In accelerometers in which a temperature differential is critical, two heating elements may react quickly and identically, affording a great advantage over heating systems requiring dual temperature control electronics. In this way, the proof mass assembly may be maintained at a relatively uniform temperature that reduces measurement errors that may result from spatial differences in temperature across the proof mass assembly.

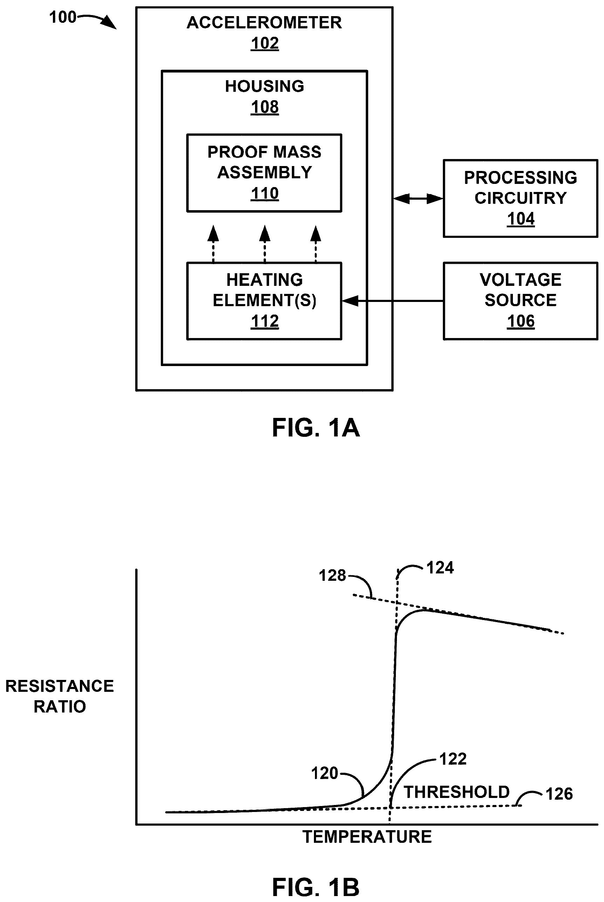

FIG. 1A is a block diagram illustrating an example accelerometer system 100. Accelerometer system 100 includes an accelerometer 102, processing circuitry 104, and a voltage source 106. Accelerometer 102 includes a housing 108, a proof mass assembly 110 encased in housing 108, and one or more heating elements 112 (singularly, "heating element 112") coupled to housing 108. Housing 108 is configured to encase one or more components of accelerometer 102, including proof mass assembly 110 and heating elements 112, and provide a protective environment for relatively sensitive components of accelerometer 102. In some examples, housing 108 may be configured to assist in maintaining a temperature within housing 108. For example, housing 108 may include one or more insulative materials that reduce an amount of heat transferred across housing 108.

As mentioned above, accelerometer 102 may be subject to thermal transients that may otherwise cause measurement errors if not corrected or compensated. For example, changes in temperature may cause a zero output of accelerometer 102 to drift, cause a resonant frequency of accelerometer 102 to change (e.g., for vibrating beam accelerometers), cause spatial differences in thermal expansion and contraction due to different materials and/or different temperatures, and/or cause a difference in electrical properties of components of accelerometer 102. Many of these errors may result from temporal differences in temperature among all components or spatial differences in temperature between differential components (e.g., components that are used to generate signals that are compares, such as different resonators).

Each heating element 112 is configured to generate heat in response to an electrical current via resistive heating and maintain a temperature of proof mass assembly 110 at or near a threshold temperature. Once at or near the threshold temperature, heating elements 112 may output a relatively small amount of power, including at steady state or in response to a thermal transient. For accelerometers 102 that measure acceleration using differential components, heating elements 112 may be positioned proximate to the differential components to reduce spatial variation in temperature.

Each heating element 112 includes a positive temperature coefficient of resistance (PTC) material. In response to a thermal transient that may otherwise cause a large change in temperature, the PTC material is configured to cause a substantially smaller change in temperature, and thereby maintain a reduced error of the acceleration. For example, an error of the acceleration calculated may be maintained below a threshold error value for more than a threshold amount of time.

FIG. 1B is a graph illustrating resistance ratio versus temperature for an example positive temperature coefficient (PTC) material 120. A resistance ratio may represent a ratio of electrical resistance of PTC material 120 at a particular temperature versus electrical resistance of PTC material 120 at room temperature. PTC material 120 exhibits a relatively high increase in resistance above a threshold temperature 122, as indicated by a threshold slope 124. At temperatures lower than threshold temperature 122, PTC material 120 exhibits a relatively low resistance, as indicated by a sub-threshold slope 126. At temperatures higher than the threshold temperature 122, PTC material 120 continues to exhibit a relatively high resistance, as indicated by a super-threshold slope 128, though the resistance ratio may begin to decline with temperature. For example, as a slope change of super-threshold slop 128 increase, a temperature control may increase. A limiting factor may be a power drain on accelerometer system 100 and a possibility of damaging an interface between PTC material 120 and a portion of accelerometer system 100 on which PTC material 120 contacts due to fast heating. Threshold temperature 122 may be represented by an intersection of threshold slope 124 and sub-threshold slope 126. In some examples, a resistance ratio of PTC material 120 above the threshold temperature to the resistance of the PTC material at room temperature (PTC ratio) is greater than five.

PTC material 120 may be configured for a particular threshold temperature 122. Threshold temperature 122 may correspond to a desired temperature for which accelerometer 102 may be maintained, and which may depend on a particular use or operating environment. Accelerometer 102 may be maintained at a temperature that is sufficiently high such that thermal transients may not substantially increase temperature. For example, a thermal transient that heats housing 108 may cause a smaller increase in temperature for accelerometer 102 that is operating at a higher temperature. Additionally or alternatively, accelerometer 102 may be maintained at a temperature that is sufficiently low such that heating elements 112 may use less power during start-up and while maintaining threshold temperature 122. For example, a threshold temperature that is relatively low may require less power to heat accelerometer 102 up to an operating temperature. In some examples, threshold temperature 122 may be between about 40 °C and about 130 °C.

PTC material 120 may include a combination of components which provide PTC material 120 with temperature-dependent electrical properties. For example, PTC material 120 may include an epoxy resin that provides bond strength, such as diglycidyl ether of Bisphenol A, diglycidyl ether of Bisphenol F, novolac epoxy resins, or cycloaliphatic epoxy resins; polymer matrices, such as polyethylene or other thermoplastics; conductive fillers, such as carbon or silver, that provide electrical conductivity; and various additives, such as curing agents or stabilizers, to provide particular handling characteristics.

Without being limited to any particular theory, at lower temperatures, the conductive fillers form a network of pathways within PTC material 120, allowing electricity to flow relatively freely. These pathways offer low resistance to electrical current, resulting in PTC material 120 exhibiting a low overall resistance, such as illustrated by sub-threshold slope 126. As the temperature increases, a polymer matrix formed by the epoxy resin of PTC material 120 expands. This expansion causes the conductive filler particles to move farther apart from each other, disrupting the continuity of the conductive pathways. Near a certain transition threshold temperature (i.e., threshold temperature 122), the expansion of the polymer matrix and the resultant increase in separation between conductive filler particles become significant enough to cause a sudden rise in electrical resistance, such as illustrated by threshold slope 124. This transition temperature is a characteristic property of PTC material 120 and can be tailored during material design. Above the transition temperature, the material exhibits a positive temperature coefficient, meaning its resistance increases dramatically with temperature. This behavior occurs because the disrupted conductive pathways hinder the flow of electricity, leading to higher overall resistance in PTC material 120.

Temperature-dependent electrical properties of PTC material 120 are primarily achieved through the interaction between a polymer matrix of the epoxy resin and the conductive filler particles, which disrupt the conductive pathways as the material heats up, leading to a sharp increase in resistance. As such, selection of the epoxy resin and conductive filler, including a composition and concentration, may affect these temperature-dependent electrical properties. As one example, selection of the polymer matrix of PTC material 120 may influence thermal expansion characteristics and overall behavior of PTC material 120. Different types of polymers have varying coefficients of thermal expansion (CTE), which affect how much PTC material 120 expands or contracts with temperature changes. Selecting a polymer with a suitable CTE can help achieve the desired threshold temperature 122. As another example, a type, size, shape, and concentration of conductive filler particles, such as carbon black or metallic particles, may influence the electrical and thermal properties of PTC material 120. A higher concentration of conductive filler or a use of fillers having a higher electrical conductivity can lead to a lower threshold temperature 122, while lower concentrations or different filler types can result in a higher threshold temperature 122. As another example, relatively uniform dispersion and distribution of conductive filler particles within the polymer matrix may provide consistent performance and predictable threshold temperature 122.

In some examples, PTC material 120 includes a printable PTC ink printed on a portion of housing 108 proximate to proof mass assembly 110. For example, PTC material 120 may be capable of being deposited onto housing 108 or other component in accelerometer 102 in an uncured or partially cured state and subsequently cured to form the polymer matrix. PTC material 120 may be printed in a variety of shapes and on a variety of non-conductive or semi-conductive substrates. For example, PTC material 120 may be printed as a substantially one-dimensional form that provides a relatively small cross-sectional area for an overall length of heating element 112.

Referring back to FIG. 1A, each heating element 112 may be electrically coupled to voltage source 106. Voltage source 106 may be configured to apply a voltage to heating elements 112 to generate the electrical current. The power generated by voltage source 106 may be sufficient to quickly heat accelerometer 102 to an operating temperature corresponding to threshold temperature 122.

Processing circuitry 104 may be configured to determine one or more parameters corresponding to characteristics of the proof mass assembly. Processing circuitry 104 may be configured to calculate an acceleration based on the one or more parameters of the proof mass assembly. PTC material 120 may be configured to maintain, in response to a thermal transient, an error of the acceleration calculated based on the one or more parameters below a threshold error value for more than a threshold amount of time. In some examples, processing circuitry 104 may further measure a current delivered to PTC material 120. For example, while external active control circuitry is not necessary to regulate a temperature of PTC material 120, determination of temperature and/or temperature gradients based on the measured current may be useful for monitoring accelerometer system 100.

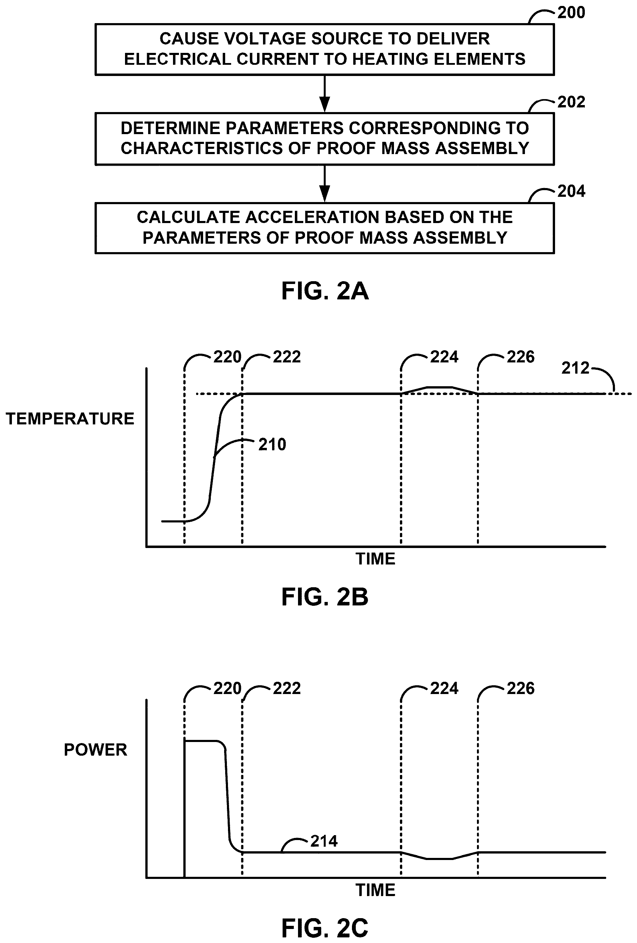

FIG. 2A is a flow diagram illustrating operation of one or more heating elements of an example accelerometer system to measure acceleration. FIG. 2A may be described with reference to accelerometer system 100 of FIG. 1A and PTC material 120 of FIG. 1B, and may further reference FIGS. 2B and 2C. A method for measuring acceleration includes causing, by processing circuitry 104, voltage source 106 to deliver an electrical current to one or more heating elements 112 to generate heat (200). As discussed above, heating elements 112 include PTC material 120 that exhibits a relatively high increase in resistance above a threshold temperature. In contrast to processing circuitry used for active heat control, in the example of FIG. 2A, processing circuitry 104 for operating heating elements 112 to generate heat may be simple without any feedback, and may simply control whether a current flows to heating elements 112 and how much current is flowing to heating elements 112.

The method further includes determining, by processing circuitry 104, one or more parameters corresponding to characteristics of proof mass assembly 110 that change as a result of acceleration (202). For example, for a vibrating beam accelerometer, acceleration may cause a change in frequency of a vibrating beam, which may be output as a current signal or pair of current signals to electronics in processing circuitry 104. The frequency may be sensitive to differences in temperature, such that a change in temperature or a difference in temperature between vibrating beams may change the current signal. The method further includes calculating, by processing circuitry 104, the acceleration based on the one or more parameters of proof mass assembly 110 (204). For example, the acceleration may be calculated from the measured frequency change. In response to a thermal transient or other change in temperature, an error of the acceleration calculated based on the one or more parameters may remain below a threshold error value for more than a threshold amount of time due to the relatively uniform temperature produced by heating elements 112.

FIG. 2B is a graph illustrating temperature 210 versus time for example accelerometer system 100 of FIG. 1A, while FIG. 2C is a graph illustrating power 214 versus time for example accelerometer system 100 of FIG. 1A. During startup 220 when electrical current is initially supplied to heating elements 112, temperature 210 of PTC material 120 may be at ambient temperature. At this point, PTC material 120 may exhibit a relatively low resistance, allowing a higher current to flow through PTC heater material 120. As the current flows through PTC material 120, PTC material 120 heats up due to Joule heating caused by current passing through heating elements 112.

As the temperature increases, the resistance of PTC material 120 also increases, leading to a higher resistance of heating elements 112. This rise in resistance helps limit the current flowing through heating elements 112, which in turn moderates the temperature of heating elements 112. As PTC material 120 heats up further, the resistance of PTC material 120 continues to increase, reaching a point 222 where PTC material 120 limits the current flow to a level that stabilizes the temperature of heating element 112. At this point 222, a PTC ratio may be relatively high, such as greater than five, and the current through heating elements 112 will be relatively stable, and power will be relatively low. Temperature 210 will be at a setpoint temperature 212 corresponding to threshold temperature 122. As such, voltage source 106 will deliver the electrical current, which maintains the temperature of components within housing 108, such as proof mass assembly 110, at or near setpoint temperature 212.

In response to a thermal transient across housing 108, voltage source 106 will deliver the electrical current to maintain the temperature of proof mass assembly 110 at or near the threshold. When thermal transient 224 occurs that increases temperature, one or more heating elements 112 may heat up, causing a resistance of PTC material 120 to also increase. As the resistance of PTC material 120 increases, electrical current through heating elements 112 decreases, helping to moderate a temperature and reduce overheating that may otherwise occur with an active heating element that does not exhibit a large increase in PTC. At a point 226, heating element 112 may return to setpoint temperature 212.

While not shown, when a thermal transient decreases temperature, the temperature of the heating element may decrease, causing the resistance of the PTC material to decrease as well. As the resistance of PTC material 120 decreases in response to the temperature decrease, the electrical current through heating element 112 increases, providing more heat output to compensate for the cooling effect of the environment.

The method of FIG. 2A includes determining, by processing circuitry 104, one or more parameters corresponding to characteristics of proof mass assembly 110. The one or more parameters may correspond to changes in acceleration. The method of FIG. 2A includes calculating, by processing circuitry 104, the acceleration based on the one or more parameters of proof mass assembly 110. PTC material 120 of heating elements 112 is configured to maintain, in response to a thermal transient such as thermal transient 224, an error of the acceleration calculated based on the one or more parameters below a threshold error value for more than a threshold amount of time. For example, the threshold error value may be about 5% and the threshold amount of time may be about 1 minute.

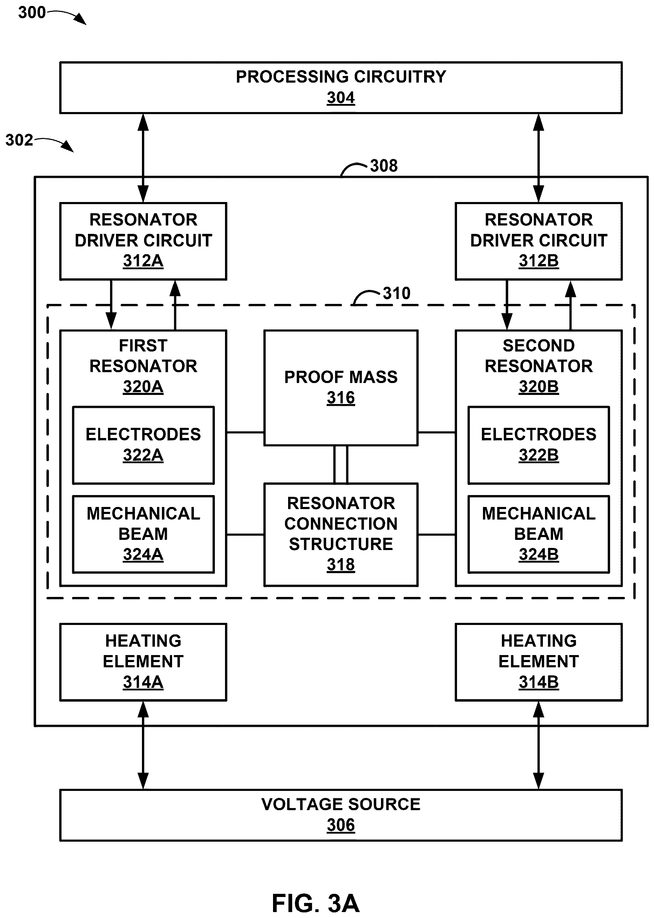

The techniques of this disclosure may be incorporated into a variety of accelerometers, and particularly accelerometers that rely on differential stabilization or actuation to balance a proof mass, such as vibrating beam accelerometers (VBA) and force rebalance accelerometers. In some examples, VBA may be used to detect displacement of a proof mass assembly. FIG. 3A is a block diagram illustrating an example accelerometer system 300 including a vibrating beam accelerometer 302 that includes one or more heating elements 314. Accelerometer system 300 includes accelerometer 302, processing circuitry 304, and voltage source 306. Accelerometer 302 includes a housing 308, a proof mass assembly 310, one or more resonator driver circuits 312A and 312B communicatively coupled to processing circuitry 304, and one or more heating elements 314A and 314B electrically coupled to voltage source 306.

Proof mass assembly 310 includes proof mass 316, resonators 320A and 320B, and resonator connection structure 318. Proof mass 316 is connected to resonators 320 through a resonator connection structure 318. Each resonator 320 includes respective electrodes 322A and 322B and respective mechanical beams 324A and 324B. When accelerometer 302 is subjected to acceleration, proof mass 316 tends to lag behind due to inertia, causing resonators 320 to bend or deflect. Each mechanical beam 324 is configured to vibrate at a natural resonant frequency when excited by an external force. Electrodes 322 are configured to apply an electric field to mechanical beams 324, causing them to vibrate at their resonant frequencies. In some examples, electrodes 322 may also be used to detect the vibrations of mechanical beams 324 and measure their frequencies.

Resonator driver circuits 312A and 312B maintain vibrations of resonators 320A and 320B at their natural frequencies. This feedback loop adjusts the excitation signal to compensate for changes in characteristics of resonators 320, such as temperature variations or aging effects. Resonator driver circuits 312 may measure the vibrations of the resonators and convert the mechanical vibrations of resonators 320 into electrical signals that can be processed and analyzed. Processing circuitry 304 may process electrical signals from resonator driver circuits 312, which may involve amplification, filtering, and digitization of the signals to extract the relevant information about the acceleration being measured.

During operation, each resonator 320 is set into vibration at its resonant frequency by an external source. This vibration is maintained by resonator driver circuits 312 using a feedback loop to keep the resonators oscillating. Resonator driver circuits 312 detect a change in resonant frequency of each resonator 320, and a difference in frequency between resonators 320A and 320B may be directly proportional to the applied acceleration. Processing circuitry 304 receives an electrical signal proportional to the difference in resonant frequencies of resonators 320, which is then amplified and processed to obtain the desired acceleration data.

Proof mass assembly 310 is mounted on housing 308, which provides support and protection for delicate components of proof mass assembly 310. Housing 308 also ensures that resonators 320 are aligned properly and can vibrate freely without interference. To maintain a temperature within housing 308, accelerometer 302 includes one or more heating elements 314A and 314B coupled to a voltage source 306. Heating elements 314 may operate as described with respect to heating elements 112 of FIGS. 1A and 1B. In the example of FIG. 3A, accelerometer 302 includes two heating elements 314 to apply heat near each resonator 320; however, any number of heating elements may be used. Heating elements 314 may be positioned proximate to temperature-sensitive components, such as resonators 320, to reduce a change in vibration caused by a change in temperature and/or a temperature-induced difference in vibration between resonators 320. Heating elements 314 may be coupled to any portion of housing 308. In some examples, housing 308 includes one or more damping plates positioned proximate to proof mass assembly 310, such as proximate resonators 320. Heating elements 314 may be positioned on the damping plates, such that heating elements 314 are proximate to resonators 320. In this way, errors that may result from changes in temperature over time and/or between components of accelerometer 302 may be reduced.

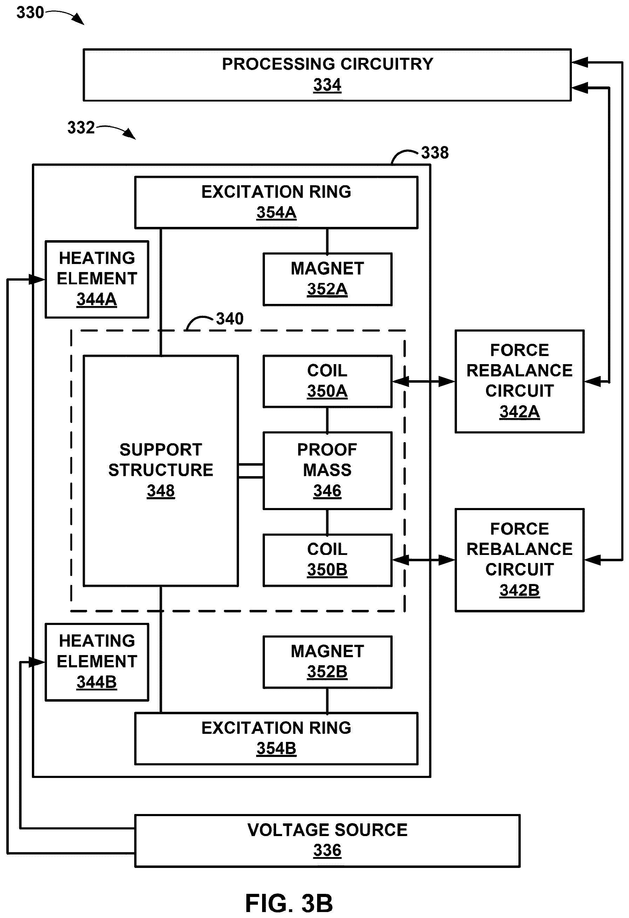

In some examples, a force rebalance system may be used to detect displacement of a proof mass assembly, and heating elements described herein may be used to control a temperature within the accelerometer. FIG. 3B is a block diagram illustrating an example accelerometer system 330 that includes a force rebalance accelerometer 332 that includes one or more heating elements 344. Accelerometer 332 is configured to detect the displacement of the proof mass assembly under inertial forces created by acceleration and produce an electrical signal that indicates the direction and magnitude of such acceleration. Accelerometer system 330 includes accelerometer 332, processing circuitry 334, and voltage source 336. Accelerometer 332 includes a housing 338, a proof mass assembly 340, one or more force rebalance circuits 342A and 342B communicatively coupled to processing circuitry 334, and one or more heating elements 344A and 344B electrically coupled to voltage source 336.

Proof mass assembly 340 includes proof mass 346, force rebalance coils 350A and 350B, and support structure 348. Force rebalance coils 350 are mounted on either side of proof mass assembly 340. Force rebalance coils 350 cooperate with a magnetic flux path that includes permanent magnets 352A and 352B and excitation rings 354A and 354B, and with force rebalance circuits 342A and 342B to retain proof mass assembly 340 at a predetermined position (i.e., a null position) with respect to support structure 348. For example, the force from the movement stimulus will attempt to displace proof mass 346. The current in force rebalance coils 350A and 350B will be increased by a servo to maintain the null position of proof mass assembly 340 by driving the differential capacitance from the pick-offs to zero. The current increase in force rebalance coils 350 provides the opposite force required for maintaining the null position of proof mass assembly 340, and the increase in current will be proportional to the applied movement stimulus. Processing circuitry 334 may determine acceleration based on the change in the current increase in the force rebalance coils to maintain the proof mass in the null position.

During operation, processing circuitry 334 may be configured to maintain proof mass 346 of proof mass assembly 340 at the null position when accelerometer 332 experiences a movement stimulus, such as acceleration. For example, the force from movement stimulus will attempt to displace the proof mass 346. Force rebalance circuits 342A and 342B may distribute current to force rebalance coils 350A and 350B of proof mass assembly 340 such that force rebalance coils 350A and 350B may interact with a permanent magnet 352A and 352B to provide the opposite force required for maintaining the null position of proof mass 346. By causing proof mass 346 of proof mass assembly 340 to return to the null position, processing circuitry 334 may drive the differential capacitance from the pick-offs to zero.

Proof mass assembly 340 is mounted housing 338, which provides support and protection for delicate components of proof mass assembly 340. To maintain a temperature within housing 338, accelerometer 332 includes one or more heating elements 344A and 344B. Heating elements 344 may operate as described with respect to heating elements 112 of FIGS. 1A and 1B. In the example of FIG. 3B, accelerometer 332 includes two heating elements 344 to apply heat near each coil 350; however, any number of heating elements may be used. Heating elements 344 may be positioned proximate to temperature-sensitive components, such as coils 350, to reduce thermal stresses caused by a change in temperature and/or a difference in temperature between sides of proof mass assembly 340. Heating elements 344 may be coupled to any portion of housing 338 and/or the magnetic flux path. In some examples, heating elements 314 may be positioned on excitation rings 354A and/or 354B supporting proof mass assembly 340, such that heating elements 344 are proximate to coils 350A. In this way, errors that may result from changes in temperature over time and/or between components of accelerometer 332 may be reduced.

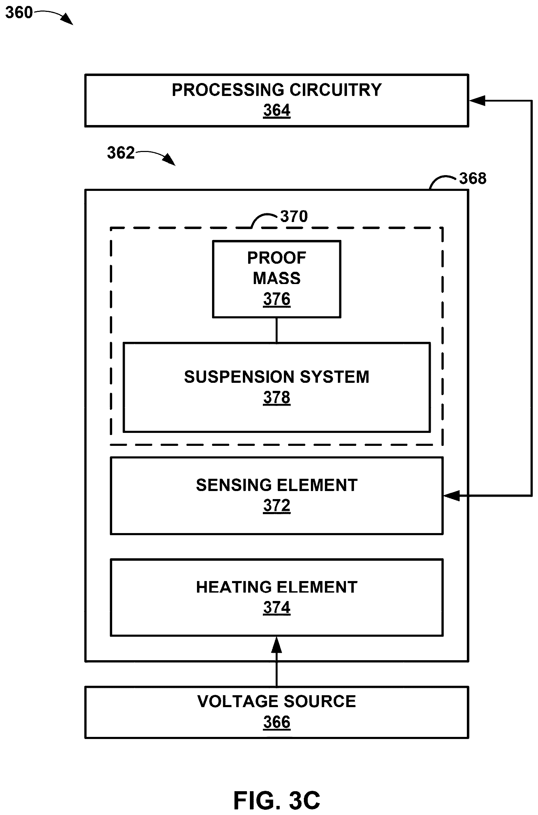

In some examples, an accelerometer may be a micro electromechanical system (MEMS), and heating elements described herein may be used to control a temperature for this small form factor. FIG. 3C is a block diagram illustrating an example accelerometer system 360 that includes an MEMS accelerometer 362 that includes one or more heating elements 374. Accelerometer 362 includes mechanical elements, sensors, actuators, and electronics that are integrated into a single semiconductor chip or substrate, such as by using microfabrication techniques. MEMS accelerometer 362 may include accelerometer components that are miniaturized, and may be mass produced at a lower cost compared to traditional macro-scale accelerometers. Accelerometer system 360 includes accelerometer 362, processing circuitry 364, and voltage source 366. Accelerometer 362 includes a packaging 368, a proof mass assembly 370, one or more sensing elements 372 communicatively coupled to processing circuitry 364, and one or more heating elements 374 electrically coupled to voltage source 366.

Proof mass assembly 370 includes a proof mass 376 and a suspension system 378 coupled to proof mass 376 and configured to permit movement of proof mass 376. Proof mass 376 may include a small, suspended mass that moves in response to acceleration, and the displacement or movement is measured to determine the acceleration. Proof mass 376 is suspended within accelerometer 362 by suspension system 378, such as by using tiny beams or springs. Suspension system 378 permits proof mass 376 to move in response to acceleration while providing stability and control.

Sensing element 372 is configured to detect movement or displacement of proof mass 376. A variety of mechanisms may be used to detect movement or displacement including, but not limited to, capacitance, piezoelectricity, or piezoresistivity, force rebalance, or resonance. Sensing element 372 may be coupled to is processing circuitry 364. Processing circuitry 364 may be configured to amplify, process, and/or convert the detected motion into a measurable electrical signal. This signal may be further processed to calculate the acceleration.

To protect the delicate internal components, such as electrical components, from external influences such as temperature changes, moisture, or physical damage, MEMS accelerometer 362 includes protective packaging 368. To maintain a temperature of accelerometer 362, accelerometer 362 includes one or more heating elements 374. Heating element 374 may operate as described with respect to heating elements 112 of FIGS. 1A and 1B. Heating element 374 may be positioned on or within packaging 368, such as on or encapsulated by an insulative polymer of packaging 368. In this way, errors that may result from changes in temperature over time and/or between components of accelerometer 362 may be reduced.

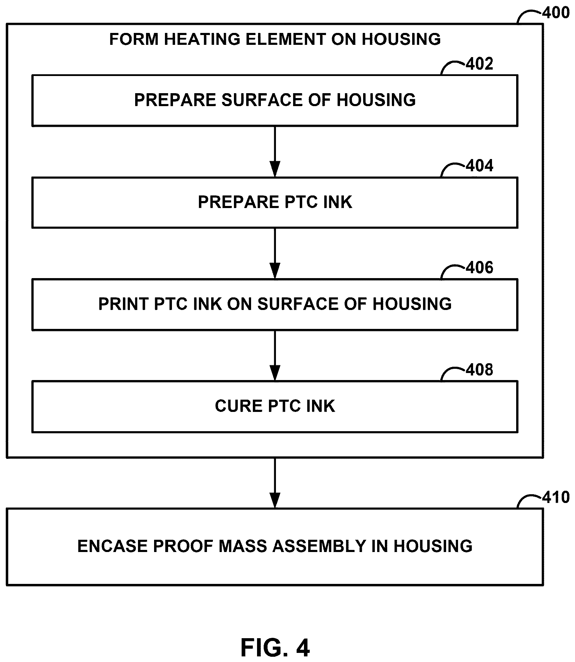

FIG. 4 is a flow diagram illustrating an example technique for fabricating an accelerometer that includes one or more heating elements. The example technique of FIG. 4 will be illustrated with respect to heating elements 112 of FIG. 1A.

The example technique includes forming one or more heating elements 112 on at least one of housing 108 or other component adjacent to proof mass assembly 110 (400). As discussed above, the one or more heating elements 112 are configured to heat proof mass assembly 110 in response to an electrical current. Heating elements 112 include a positive temperature coefficient of resistance (PTC) material that exhibits a relatively high increase in resistance above a threshold temperature. For example, a ratio of the resistance of the PTC material above the threshold temperature to the resistance of the PTC material at room temperature (PTC ratio) is greater than five.

In some examples, forming heating elements 112 includes printing a printable PTC ink on housing 108. A surface of a portion of housing 108 onto which the PTC ink is to be printed may be prepared (402), such as by cleaning the surface to remove any contaminants that could interfere with ink adhesion. The PTC ink may be prepared (404), such as by selecting the PTC ink, and optionally mixing or diluting the PTC ink to achieve a desired viscosity for printing. A composition of the printable PTC ink may be selected such that heating element 112 maintains a threshold temperature that corresponds to a design operating temperature of accelerometer 102. This design operating temperature may be about equal to the threshold temperature, or may be different depending on heat losses from accelerometer to an external environment. Heating element 112 may be configured with a desired shape, size, power output, and temperature regulation characteristics.

The PTC ink may be printed on the surface of housing 108 (406) in the desired shape, width, and thickness to achieve the desired power output. During printing, a variety of printing methods may be used including, but not limited to, screen printing or inkjet printing, to deposit the PTC ink onto the surface of housing 108 in the desired pattern for heating element 112. After printing, the resin of the PTC ink may be cured (408), such as through air drying, heat curing, ultraviolet (UV) curing, such that the resulting polymer matrix may adhere to the surface of housing 108, and heating element 112 may have a desired set of electrical properties. Heating element 112 may be electrically coupled to voltage source 106.

The example technique further includes encasing proof mass assembly 110 in housing 108 (410). For example, housing 108 may be secured or otherwise applied around proof mass assembly 110 to maintain a controlled environment around proof mass assembly 110.

In one or more examples, the accelerometers described herein may utilize hardware, software, firmware, or any combination thereof for achieving the functions described. Those functions implemented in software may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processors to retrieve instructions, code and/or data structures for implementation of the techniques described in this disclosure.

Instructions may be executed by one or more processors within the accelerometer or communicatively coupled to the accelerometer. The one or more processors may, for example, include one or more DSPs, general purpose microprocessors, application specific integrated circuits ASICs, FPGAs, or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules configured for performing the techniques described herein. Also, the techniques could be fully implemented in one or more circuits or logic elements.

The techniques of this disclosure may be implemented in a wide variety of devices or apparatuses that include integrated circuits (ICs) or sets of ICs (e.g., chip sets). Various components, modules, or units are described in this disclosure to emphasize functional aspects of devices configured to perform the disclosed techniques, but do not necessarily require realization by different hardware units. Rather, various units may be combined or provided by a collection of interoperative hardware units, including one or more processors as described above, in conjunction with suitable software and/or firmware.

Example 1: An accelerometer system includes an accelerometer includes a housing; a proof mass assembly encased in the housing; and one or more heating elements coupled to the housing and configured to generate heat in response to an electrical current, wherein the one or more heating elements include a positive temperature coefficient of resistance (PTC) material, and wherein the PTC material exhibits a relatively high increase in resistance above a threshold temperature.

Example 2: The accelerometer system of example 1, wherein the one or more heating elements are configured to maintain a temperature of the proof mass assembly at or near the threshold temperature.

Example 3: The accelerometer system of example 2, further comprising a voltage source configured to apply a voltage to the one or more heating elements to generate the electrical current.

Example 4: The accelerometer system of any of examples 1 through 3, wherein a ratio of the resistance of the PTC material above the threshold temperature to the resistance of the PTC material at room temperature (PTC ratio) is greater than five.

Example 5: The accelerometer system of any of examples 1 through 4, wherein the PTC material comprises a polymer matrix and conductive filler particles dispersed in the polymer matrix.

Example 6: The accelerometer system of any of examples 1 through 5, wherein the PTC material comprises a printable PTC ink printed on a portion of the housing proximate to the proof mass assembly.

Example 7: The accelerometer system of any of examples 1 through 6, wherein the accelerometer comprises a vibrating beam accelerometer, wherein the vibrating beam accelerometer comprises a damping plate proximate to the proof mass assembly, and wherein the one or more heating elements are positioned on the damping plate.

Example 8: The accelerometer system of any of examples 1 through 7, wherein the accelerometer comprises a force rebalance accelerometer, wherein the force rebalance accelerometer comprises an excitation ring supporting the proof mass assembly, and wherein the one or more heating elements are positioned on the excitation ring.

Example 9: The accelerometer system of any of examples 1 through 8, wherein the accelerometer comprises a micro electromechanical system (MEMS) accelerometer, wherein the housing of the MEMS accelerometer comprises packaging surrounding electronics, and wherein the one or more heating elements are positioned on the packaging.

Example 10: The accelerometer of any of examples 1 through 9, further includes determine one or more parameters corresponding to characteristics of the proof mass assembly; and calculate an acceleration based on the one or more parameters of the proof mass assembly, wherein the PTC material is configured to maintain, in response to a thermal transient, an error of the acceleration calculated based on the one or more parameters below a threshold error value for more than a threshold amount of time.

Example 11: A method for forming an accelerometer includes forming one or more heating elements on at least one of a proof mass assembly or a housing for encasing the proof mass assembly, wherein the one or more heating elements are configured to heat the proof mass assembly in response to an electrical current, wherein the one or more heating elements include a positive temperature coefficient of resistance (PTC) material, and wherein the PTC material exhibits a relatively high increase in resistance above a threshold temperature; and encasing the proof mass assembly in the housing.

Example 12: The method of example 11, wherein forming the one or more heating elements includes printing a printable PTC ink on a non-electrically conductive housing or with an electrically non-conductive material between the heater and the housing.

Example 13: The method of example 12, wherein the printable PTC ink is printed on a portion of the housing proximate to the proof mass assembly.

Example 14: The method of any of examples 12 and 13, wherein the printable PTC ink comprises a mixture of an uncured resin and conductive filler particles dispersed in the uncured resin, and wherein forming the one or more heating elements comprises: depositing the mixture; and curing the uncured resin to form a polymer matrix that includes the conductive filler particles dispersed in the polymer matrix.

Example 15: The method of any of examples 11 through 14, wherein a ratio of the resistance of the PTC material above the threshold temperature to the resistance of the PTC material at room temperature (PTC ratio) is greater than five.

Example 16: A method for measuring acceleration includes causing, by processing circuitry, a voltage source to deliver an electrical current to one or more heating elements to heat a proof mass assembly encased in a housing, wherein the one or more heating elements include a positive temperature coefficient of resistance (PTC) material, and wherein the PTC material exhibits a relatively high increase in resistance above a threshold temperature; determining, by the processing circuitry, one or more parameters corresponding to characteristics of the proof mass assembly; and calculating, by the processing circuitry, the acceleration based on the one or more parameters of the proof mass assembly.

Example 17: The method of example 16, wherein the PTC material is configured to maintain, in response to a thermal transient, an error of the acceleration calculated based on the one or more parameters below a threshold error value for more than a threshold amount of time.

Example 18: The method of any of examples 16 and 17, wherein causing the voltage source to deliver the electrical current maintains a temperature of the proof mass assembly at or near the threshold temperature.

Example 19: The method of example 18, wherein causing the voltage source to deliver the electrical current maintains the temperature of the proof mass assembly at or near the threshold temperature in response to a thermal transient across the housing.

Example 20: The method of any of examples 16 through 19, wherein a ratio of the resistance of the PTC material above the threshold temperature to the resistance of the PTC material at room temperature (PTC ratio) is greater than five.

Various examples of the disclosure have been described. These and other examples are within the scope of the following claims.

## Claims

1. An accelerometer system comprising:
an accelerometer comprising:
a housing;
a proof mass assembly encased in the housing; and
one or more heating elements coupled to the housing and configured to generate heat in response to an electrical current, wherein the one or more heating elements include a positive temperature coefficient of resistance (PTC) material, and wherein the PTC material exhibits a relatively high increase in resistance above a threshold temperature.

2. The accelerometer system of claim 1, wherein the one or more heating elements are configured to maintain a temperature of the proof mass assembly at or near the threshold temperature.

3. The accelerometer system of claim 2, further comprising a voltage source configured to apply a voltage to the one or more heating elements to generate the electrical current.

4. The accelerometer system of any of claims 1 to 3, wherein a ratio of the resistance of the PTC material above the threshold temperature to the resistance of the PTC material at room temperature (PTC ratio) is greater than five.

5. The accelerometer system of any of claims 1 to 4, wherein the PTC material comprises a polymer matrix and conductive filler particles dispersed in the polymer matrix.

6. The accelerometer system of any of claims 1 to 5, wherein the PTC material comprises a printable PTC ink printed on a portion of the housing proximate to the proof mass assembly.

7. The accelerometer system of any of claims 1 to 6,
wherein the accelerometer comprises a vibrating beam accelerometer,
wherein the vibrating beam accelerometer comprises a damping plate proximate to the proof mass assembly, and
wherein the one or more heating elements are positioned on the damping plate.

8. The accelerometer system of any of claims 1 to 6,
wherein the accelerometer comprises a force rebalance accelerometer,
wherein the force rebalance accelerometer comprises an excitation ring supporting the proof mass assembly, and
wherein the one or more heating elements are positioned on the excitation ring.

9. The accelerometer system of any of claims 1 to 6,
wherein the accelerometer comprises a micro electromechanical system (MEMS) accelerometer,
wherein the housing of the MEMS accelerometer comprises packaging surrounding electronics, and
wherein the one or more heating elements are positioned on the packaging.

10. The accelerometer system of any of claims 1 to 9, further comprising processing circuitry configured to:
determine one or more parameters corresponding to characteristics of the proof mass assembly; and
calculate an acceleration based on the one or more parameters of the proof mass assembly, wherein the PTC material is configured to maintain, in response to a thermal transient, an error of the acceleration calculated based on the one or more parameters below a threshold error value for more than a threshold amount of time.

11. A method for measuring acceleration, comprising:
causing, by processing circuitry, a voltage source to deliver an electrical current to one or more heating elements to heat a proof mass assembly encased in a housing, wherein the one or more heating elements include a positive temperature coefficient of resistance (PTC) material, and wherein the PTC material exhibits a relatively high increase in resistance above a threshold temperature;
determining, by the processing circuitry, one or more parameters corresponding to characteristics of the proof mass assembly; and
calculating, by the processing circuitry, the acceleration based on the one or more parameters of the proof mass assembly.

12. The method of claim 11, wherein the PTC material is configured to maintain, in response to a thermal transient, an error of the acceleration calculated based on the one or more parameters below a threshold error value for more than a threshold amount of time.

13. The method of claim 11 or 12, wherein causing the voltage source to deliver the electrical current maintains a temperature of the proof mass assembly at or near the threshold temperature.

14. The method of claim 13, wherein causing the voltage source to deliver the electrical current maintains the temperature of the proof mass assembly at or near the threshold temperature in response to a thermal transient across the housing.

15. The method of any of claims 11 to 14, wherein a ratio of the resistance of the PTC material above the threshold temperature to the resistance of the PTC material at room temperature (PTC ratio) is greater than five.
